# EUROPEAN PATENT APPLICATION

(11) **EP 1 369 913 A2**
(43) Date of publication of application: **10.12.2003**
(21) Application number: 03253366.3
(22) Date of filing: 29.05.2003
(51) Int. Cl.: H01L 21/768

(54) **Method of patterning inter-metal dielectric layers**

(30) Priority: 05.06.2002 KR 2002031547
(71) Applicant: SAMSUNG ELECTRONICS CO., LTD., Suwon-City, Kyungki-do 442-742 (KR)
(72) Inventor: Lee, Kwang Hee, Suwon-Shin, Kyungki-Do 442-724 (KR); Jeong, Hyun Dam, Suwon-Shin, Kyungki-Do 442-707 (KR); Lee, Soo Geun, Suwon-Shin, Kyungki-Do 442-707 (KR); Lee, Kyoung Woo, Seoul 150-778 (KR)
(74) Representative: Kyle, Diana

(57) **Abstract**

Disclosed is a method of patterning inter-metal dielectric layers. The method comprises a) sequentially layering a lower etch-stop layer (2), a lower dielectric layer (3), an upper etch-stop layer (4), and an upper dielectric layer (5) on a semiconductor substrate including a lower circuit (1) patterned thereon, b) patterning the upper dielectric layer (5), the upper etch-stop layer (4), and the lower dielectric layer (3) to form a via hole (7) to expose the lower etch-stop layer (2) on the lower circuit, c) irradiating UV rays to the via hole (7), d) forming a photoresist layer (8) on the resulting semiconductor substrate including the via hole thereon, and patterning the photoresist layer, e) patterning the upper dielectric layer using the patterned photoresist layer (9) as an etching mask to form a metal circuit around the via hole (7) in the upper dielectric layer (5), and f) exposing an upper portion of the lower circuit (11). Additionally, the method is advantageous in that a metal circuit is formed in the inter-metal dielectric layers according to a dual damascene process, thereby easily removing a photoresist residue, which is difficult to remove during developing the photoresist layer, and preventing an increase in the dielectric constant of porous dielectric layers caused by the absorption of water into the porous dielectric layers.

## Description

The present invention relates to a method of patterning inter-metal dielectric layers and, more particularly, to a method of patterning inter-metal dielectric layers, wherein generation of a photoresist residue on a wall of a via hole is totally prevented by irradiating UV to the via hole after its formation.

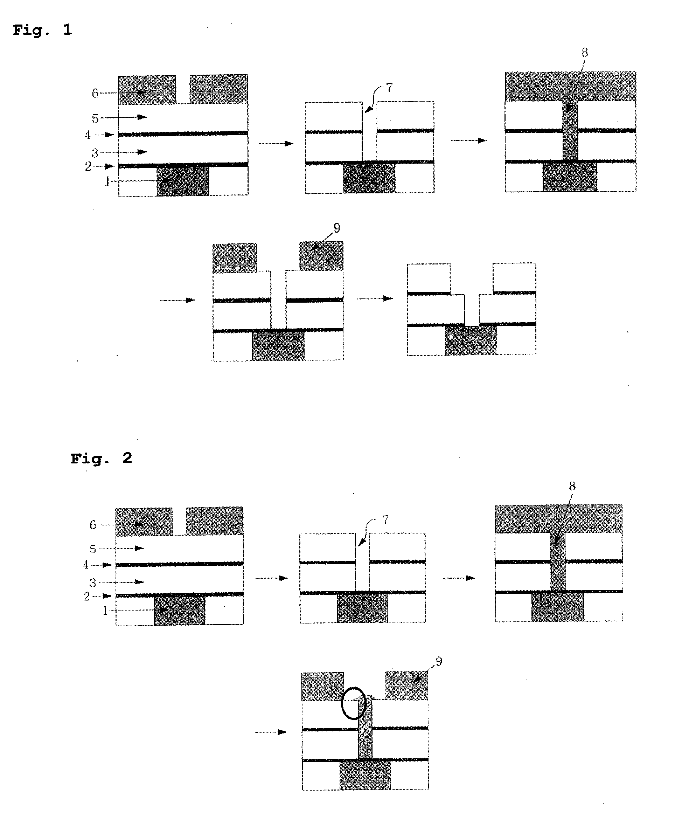

Among many process of manufacturing semiconductor devices, dual damascene process is on growing demand in the field of patterning metal circuit and, in FIG. 1, its conventional process is illustrated. In this process, dual dielectric layers, that is upper and lower layers, are coated on a semiconductor substrate having an exposed lower circuit, a via hole is formed through the lower dielectric layer to connect an upper and lower circuit to each other, and, after a pattern for the upper circuit is formed in the upper dielectric layer, a metal is plugged in the pattern to form a resulting structure. The resulting structure obtained by the above process goes through CMP (Chemical and Mechanical Polishing) process and thereby a formation of the desired circuit on the semiconductor substrate is achieved.

More specifically, the lower circuit 1 is formed on the semiconductor substrate, and a lower etch-stop layer 2, the lower dielectric layer 3, an upper etch-stop layer 4, and the upper dielectric layer 5 are sequentially layered on the substrate including the lower circuit 1. A photoresist is coated on the resulting substrate and, is exposed and developed to form a photoresist pattern 6. The developed substrate is firstly dry-etched using the photoresist pattern 6 as a mask to sequentially etch the upper dielectric layer 5, the upper etch-stop layer 4, and the lower dielectric layer 3, thereby forming a via hole 7 to expose the lower etch-stop layer 2 on the lower circuit 1. To form an upper metal circuit line, a photoresist 8 is then coated on the substrate including the via hole 7, and is exposed and developed to form a photoresist pattern 9. After that, the upper dielectric layer 5 is secondly etched using the photoresist pattern 9 as the mask and, then, the upper and lower etch-stop layers 4 and 2 are simultaneously and secondly etched to form a via hole pattern to connect an upper metal circuit to both the upper and lower circuits.

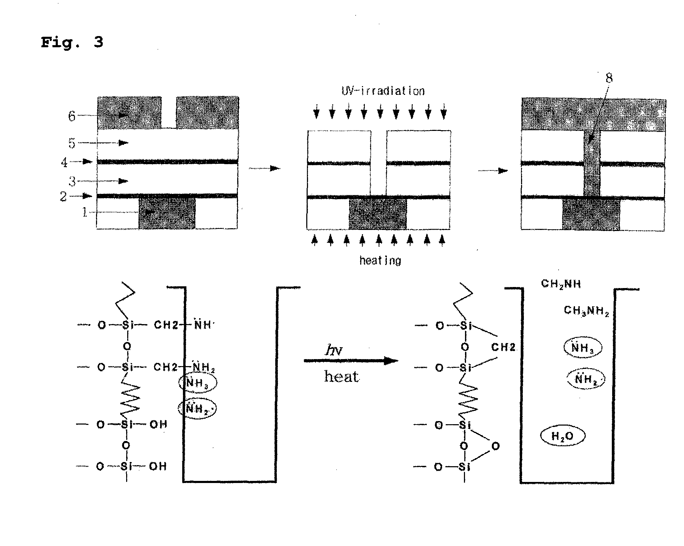

However, in the conventional dual damascene process, if a first etching process is conducted by using N₂ gas, an amine group (e.g. NH₂- ) is formed on the wall of the via hole. The amine group thus formed functions to trap H⁺ ions in the photoresist during a photolithography process which is one of post-processes for forming the upper circuit line, and thus, after an exposure and development, a photoresist residue is not eliminated and left on the wall of the via hole. Accordingly, an undesirable pattern is formed during a second etching process, resulting in inferior electronic elements as shown in FIG. 2.

Hence, much effort has made been to reduce an amount of the N₂ gas used during forming the via hole. However, in order to control an etching rate properly and to improve selectivity during etching a low-dielectric layer, the use of N₂ gas is inevitable when the carbon-containing dielectric layer is used for better properties of layers.

In this regard, a process of preventing trapping H⁺ ions has been developed, wherein a low-dielectric material (dielectric constant k ≒ 3.2) containing fluorine is filled in a contact hole, and subjected to a photolithography process. This process is advantageous in that when a photoresist is stripped using an HF solution after an etching and ashing process of a low-dielectric layer, the low-dielectric material containing fluorine is stripped in conjunction with the photoresist. Accordingly, this process is useful in the case of using lower dielectric layers containing no pores and having a dielectric constant (k) of 2.7. However, the process is insufficiently competitive in the case of using the porous low-dielectric layers because it is difficult to secure a desired pattern when the etching rate of a nonporous low-dielectric material containing fluorine is not the same to that of the porous low-dielectric layer during etching the nonporous and porous dielectric layers. In other words, the nonporous low-dielectric material containing fluorine is slowly etched because the etching rate of the porous low-dielectric layer is higher than that of the low-dielectric layer containing no pores. Therefore, such a process fails to form proper damascene structure.

Meanwhile, in the case of using the porous low-dielectric layers containing nano-sized pores, a silanol group (≡Si-OH) is generated on the dielectric layers because the dielectric layers are exposed to plasma in the etching process of the dielectric layers, thereby making the wall of the via hole hydrophilic. As described above, when the wall of the via hole is hydrophilic, the via hole absorbs a great quantity of water in a wet-cleaning process, thus undesirably increasing the dielectric constant of the low-dielectric layers and reducing reliability of the low-dielectric layers.

The present invention has been made with the above problems of the prior art in mind, and therefore an object of the present invention is to provide a method of patterning inter-metal dielectric layers by an dual damascene process, in which, after forming a via hole in a dielectric layers, UV rays are irradiated so as to modify a chemical structure of a wall of the via hole and to reduce its reactivity, thereby easily removing a photoresist residue, which is difficult to remove during a developing process.

Based on the present invention, the above object can be accomplished by providing a method of patterning inter-metal dielectric layers, comprising steps of a) sequentially layering a lower etch-stop layer, a lower dielectric layer, an upper etch-stop layer, and an upper dielectric layer on a semiconductor substrate including a lower circuit patterned thereon, b) patterning the upper dielectric layer, the upper etch-stop layer, and the lower dielectric layer to form a via hole, exposing the lower etch-stop layer on the lower circuit, c) irradiating UV rays to the via hole, d) forming a photoresist layer on the resulting semiconductor substrate including the via hole thereon, and patterning the photoresist layer, e) patterning the upper dielectric layer using the patterned photoresist layer as an etching mask to form a circuit line around the via hole in the upper dielectric layer, and f) exposing an upper portion of the lower circuit.

The above and other objects, features and other advantages of the present invention will be more clearly understood from the following detailed description taken in conjunction with the accompanying drawings, in which:
FIG. 1 illustrates a procedure of patterning inter-metal dielectric layers according to a conventional dual damascene process;
FIG. 2 illustrates the procedure of patterning the inter-metal dielectric layers according to the conventional dual damascene process, in which a photoresist residue is not completely removed from a via hole but remains in the via hole;
FIG. 3 illustrates a chemical modification of the components constituting a wall of a via hole when UV rays are irradiated to the via hole during an improved dual damascene process, according to the present invention;
FIG. 4 is a histogram illustrating contents of chemical components of dielectric layers after the deposition and etching process of the dielectric layers when the dielectric layers are analyzed by a TOF-SIMS analysis in example 1;
FIG. 5 is a histogram illustrating contents of chemical components of the dielectric layers after the etching process of the dielectric layers and the UV irradiation process when the dielectric layers are analyzed by the TOF-SIMS analysis in example 1;
FIG. 6 is a picture, taken by an electronic microscope, of a photoresist pattern after a UV irradiation process in example 2; and
FIG. 7 is a picture, taken by the electronic microscope, of a photoresist pattern not subjected to any UV irradiation process in example 2.

According to the present invention, after a via hole is formed in upper and lower dielectric layers which are layered on a semiconductor substrate, UV rays are irradiated to the via hole in order to modify a chemical structure of a wall of the via hole and to reduce its reactivity, thereby easily removing a photoresist residue, which is difficult to remove during developing a photoresist. Furthermore, a wall of the via hole of a low-dielectric layer containing nano-sized pores is subjected to a dehydroxylation to prevent the porous low-dielectric layer from absorbing water in a subsequent wet-cleaning process.

FIG. 3 illustrates the chemical modification of the surface of the wall when UV rays being irradiated to the via hole in the dielectric layers, according to the present invention. As shown in Fig. 3, most of amine groups on the surface of the via hole are bounded with hydrocarbon groups of a low-dielectric material and on the irradiation of the UV rays to the surface of the hole, a carbon-nitrogen bond is broken by the absorbed light energy. At this time, heat energy may be further added in conjunction with the UV rays so as to accelerate the bond-breakage.

Meanwhile, a silanol group is formed on the surface of the wall of the via hole in the case of using a porous material as the low-k (dielectric) layer as shown in FIG. 3. When the UV rays are irradiated to the wall of the via hole, an O-H bond is broken, and the resulting oxygen radical attacks adjacent Si atoms to form a Si-O-Si bond. Thus, the wall surface of the via hole is made hydrophobic, thereby preventing an increase in a dielectric constant of the dielectric layers caused by the absorption of water into the dielectric layers and preventing a reduction in the performance of an electronic element which is mounted on the semiconductor substrate including the dielectric layers and the via hole.

Additionally, in accordance of the present invention, UV rays with a specific wavelength region may be irradiated to the low-dielectric layer using a laser beam as a light source, or UV rays with a relatively long wavelength of about 700 nm or lower may be irradiated to the low-dielectric layer using a UV lamp as the light source. As well, various other light sources may be used to irradiate UV rays to the low-dielectric layer. Preferably, UV rays with a wavelength of 150 to 400 nm can be used. Furthermore, heat energy of 100 to 300°C may be further supplied to the via hole in conjunction with the UV rays for a better results.

Further, the UV rays may be irradiated to the whole upper dielectric layer, or to a portion of the upper dielectric layer etched using the photomask and exposing devices, that is, to only the via hole.

In addition, according to the present invention, it is preferable to irradiate the UV rays to the via hole after forming the via hole but before coating a photoresist for a secondary exposing process on the dielectric layers. However, it is possible to conduct the irradiation of the UV rays to the via hole after an etching or ashing process.

Meanwhile, in the present invention, a SiO₂ layer, a SiOF layer, a SiOC layer, and a porous dielectric layer, which are well known in the art, are useful as an inter-metal dielectric layer.

The porous dielectric layer may be formed by various processes, for example, a chemical vapor deposition process, or a coating and hardening process of a precursor solution containing aerogel or xerogel materials, and surfactant or porogen materials, on the semiconductor substrate.

Illustrative, but non-limiting examples of the surfactant include sulfates, sulfonates, phosphates, carboxylic acids, alkylammonium salts, gemini surfactants, cetylethylpiperidinium salts, dialkyldimethylammoniums, primary amines, poly(oxyethylene) oxides, octaethylene glycol monodecyl ether, octaethylene glycol monohexadecyl ether, and block copolymers thereof.

Furthermore, examples of the porogen materials include polycaprolactones, cyclodextrins, poly(oxyethylene) oxides, octaethylene glycol monodecyl ether, octaethylene glycol monohexadecyl ether, and block copolymers thereof, but the porogen is not limited by the above examples.

One example of an etch-stop layer useful in the present invention is a silicon carbide layer (SiC layer), a silicon carbonitride (SiCN) layer, a silicon nitride (SiN) layer, or amorphous silicon carbide (a-SiC) layer.

After a formation of the dual damascene pattern according to the present invention, metal barrier and metal can be filled. Examples of materials for the metal barrier comprise at least one metal selected from the group consisted of Ti, TiN, Ta, TaN, and amorphous silicon carbide(SiC) and Examples of materials for the metal comprise copper.

A better understanding of the present invention may be obtained in light of the following examples which are set forth to illustrate, but are not to be construed to limit the present invention.

### EXAMPLE 1: Comparison of chemical components constituting wall of a via hole before and after the irradiation of UV rays to the via hole

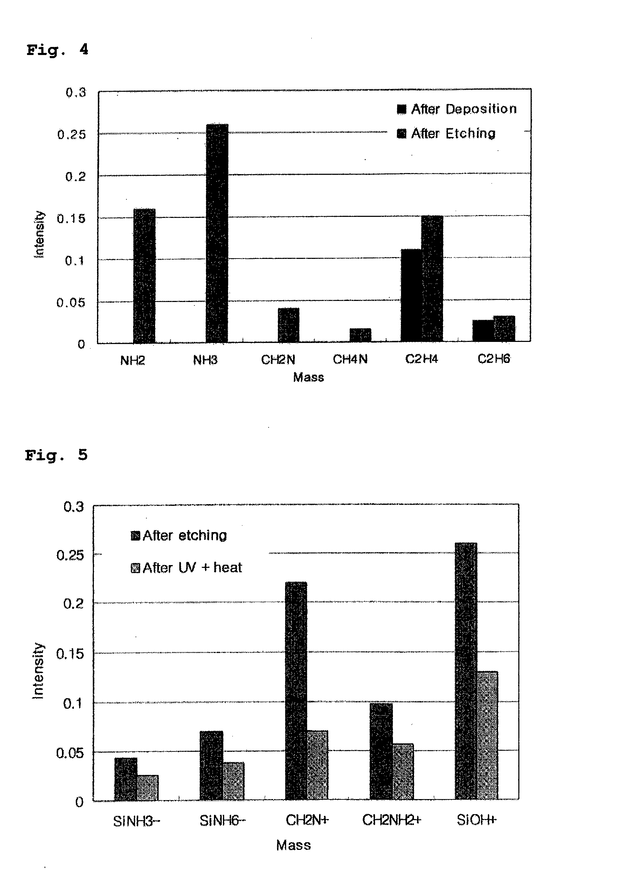

Because of difficulty in analyzing the chemical components constituting the wall of the small-sized via hole, dielectric layers (SiOC layers without pores) were layered on a semiconductor substrate and dry-etched without a photoresist pattern under an N₂ gas atmosphere, and chemical components constituting surfaces of the SiOC layers were then analyzed instead of the chemical components of the via hole by TOF-SIMS analysis. The results are illustrated in FIG. 4. From FIG. 4, it can be seen that only hydrocarbons are detected after the layering process of the dielectric layers, but great quantities of hydrogen carbonitride and ammonia-based materials containing nitrogen are detected after the dry etch process of the dielectric layers.

To compare chemical components constituting the wall of the via hole before and after the irradiation of the UV rays to the via hole, the following test was conducted, and the results are illustrated in FIG. 5. That is to say, the dielectric layers (SiOC layers without pores) were layered on the semiconductor substrate, dry-etched, and heated at 200°C while the UV rays were irradiated to the dielectric layers for 90 seconds, and the resulting structure was analyzed by TOF-SIMS analysis.

From FIG. 5, it can be seen that photoresist residues containing nitrogen on the wall of the via hole are greatly reduced and a content of SiOH in the wall of the via hole is reduced by half after the UV irradiation to the via hole.

### EXAMPLE 2: Forming of the via hole

A lower circuit was built on a semiconductor substrate, and a lower etch-stop layer, a lower dielectric layer, an upper etch-stop layer, and an upper dielectric layer were sequentially layered on the lower circuit. At this time, a silicon carbide (SiC) layer and a SiOC layer without pores were used as the upper and lower etch-stop layer and the upper and lower dielectric layer, respectively. A photoresist was then coated on the upper and lower dielectric layers, exposed and developed to form a photoresist pattern. The upper dielectric layer, upper etch-stop layer, and lower dielectric layer were sequentially dry-etched using the photoresist pattern as a mask to expose the lower etch-stop layer 2 positioned on the lower circuit, thereby forming the via hole in the dielectric layers.

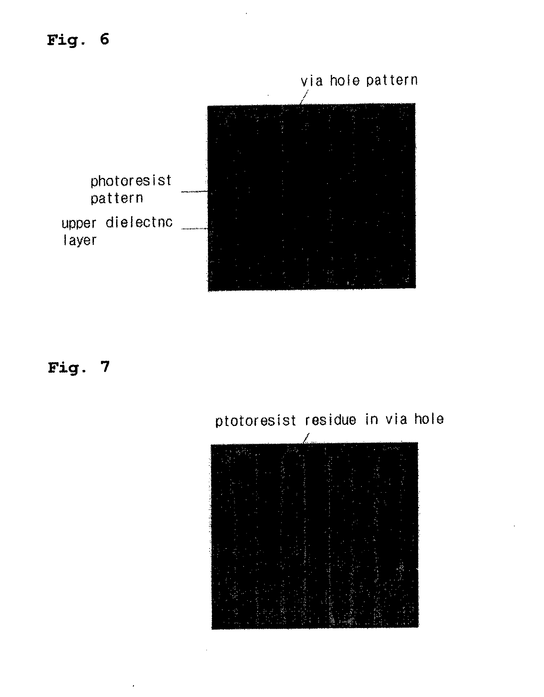

The via hole was irradiated by UV rays using a mercury light source for 60 seconds while being heated at 200°C to remove etched residue from the wall of the via hole and water absorbed/adsorbed into the wall of the via hole when the via hole is rinsed with water after the dielectric layers are etched. In this regard, another via hole acting as a control sample was not subjected to the UV irradiation. The resulting semiconductor substrate irradiated by the UV rays was coated with the photoresist, exposed, and developed to form the photoresist pattern on the upper dielectric layer. The via hole subjected to the irradiation of the UV rays and the control sample were then photographed, and the results are shown in FIGs. 6 and 7. From FIGs. 6 and 7, it can be seen that the photoresist is not removed from the via hole of FIG. 7, while the via hole and photoresist pattern are desirably formed in the case of FIG. 6.

As described above, the present invention is advantageous in that a metal circuit is formed in inter-metal dielectric layers according to the improved dual damascene process, thereby easily removing a photoresist residue, which is difficult to remove after developing the photoresist, and preventing an increase in the dielectric constant of a porous dielectric layer caused by the absorption of water into the porous dielectric layer. Another advantage of the present invention is that it is not necessary to conduct a dry procedure necessary in a wet etching process because the dielectric layers are etched according to a dry etching process, thus easily patterning inter-metal dielectric layers without additional drying devices.

The present invention has been described in an illustrative manner, and it is to be understood that the terminology used is intended to be in the nature of description rather than of limitation.

## Claims

1. A method of patterning inter-metal dielectric layers, comprising:
a) sequentially layering a lower etch-stop layer (2), a lower dielectric layer (3), an upper etch-stop layer (4), and an upper dielectric layer (5) on a semiconductor substrate, said semiconductor substrate including a lower circuit (1) patterned thereon;
b) patterning the upper dielectric layer (5), the upper etch-stop layer (4), and the lower dielectric layer (3) to form a via hole (7), said via hole exposing the lower etch-stop layer (2) on the lower circuit (1);
c) irradiating UV rays to the via hole (7);
d) forming a photoresist layer (8) on the resulting semiconductor substrate including the via hole thereon, and patterning the photoresist layer (9);
e) patterning the upper dielectric layer (5) using the patterned photoresist layer (9) as an etching mask to form a circuit line around the via hole (7) in the upper dielectric layer; and
f) exposing an upper portion of the lower circuit.

2. The method as claimed in claim 1, wherein each of the dielectric layers (3, 5) is selected from a SiO₂ layer, a SiOF layer, a SiOC layer, and a porous dielectric layer.

3. The method as claimed in claim 2, wherein the porous dielectric layer is formed by the steps of:
1) coating a precursor solution on the semiconductor substrate to form a dielectric layer on the semiconductor substrate;
2) baking the dielectric layer;
3) curing the baked dielectric layer; and
4) forming pores in the hardened dielectric layer using heat energy or UV rays.

4. The method as claimed in claim 2, wherein the porous dielectric layer is formed by a chemical vapor deposition process.

5. The method as claimed in claim 3, wherein the precursor solution contains aerogel or xerogel materials.

6. The method as claimed in claim 3, wherein the precursor solution contains surfactant materials.

7. The method as claimed in claim 3, wherein the precursor solution contains porogen materials.

8. The method as claimed in any of claims 1 to 7, wherein the etch-stop layer (4) is a silicon carbide(SiC) layer, a silicon carbonitride(SiCN) layer, a silicon nitride (SiN) layer, or amorphous silicon carbide (a-SiC) layer.

9. The method as claimed in any of claims 1 to 8, wherein the UV rays have a wavelength of 150 to 400 nm.

10. The method as claimed in any of claims 1 to 9, wherein the UV rays are irradiated to the via hole (7) while heat energy at 100 to 300°C is supplied to the via hole.
